# EUROPEAN PATENT APPLICATION

(11) **EP 3 633 362 A1**
(43) Date of publication of application: **08.04.2020**
(21) Application number: 18806859.7
(22) Date of filing: 22.05.2018
(51) Int. Cl.: G01N 24/00, C01B 32/198, C01G 23/04, C01G 33/00

(54) **NANOSHEET-CONTAINING ORIENTATION AGENT FOR NMR MEASUREMENT**

(30) Priority: 26.05.2017 JP 2017105022
(71) Applicant: Riken, Wako-shi, Saitama 351-0198 (JP); National Institute for Materials Science, Tsukuba-shi, Ibaraki 305-0047 (JP)
(72) Inventor: UCHIDA, Noriyuki, Wako-shi Saitama 351-0198 (JP); ISHIDA, Yasuhiro, Wako-shi Saitama 351-0198 (JP); UENO, Kento, Wako-shi Saitama 351-0198 (JP); SUN, Zhifang, Wako-shi Saitama 351-0198 (JP); LI, Qiaochu, Cambridge Massachusetts 02139 (US); YAMAGUCHI, Yoshiki, Wako-shi Saitama 351-0198 (JP); SASAKI, Takayoshi, Tsukuba-shi Ibaraki 305-0047 (JP); EBINA, Yasuo, Tsukuba-shi Ibaraki 305-0047 (JP); AIDA, Takuzo, Wako-shi Saitama 351-0198 (JP)
(74) Representative: Hafner & Kohl Patent- und Rechtsanwälte Partnerschaft mbB
(86) International application number: PCT/JP2018/019655
(87) International publication number: WO 2018/216689

(57) **Abstract**

Provided is an orientation agent for NMR spectroscopy containing a nanosheet which is easy to prepare, excellent in handleability, economic efficiency and versatility, and is capable of being stably aligned to the magnetic field. The nanosheet is coated with a compound having a molecular weight of 1,500 or more and containing 35 or more functional groups per molecule, said functional groups being composed of at least one selected from a hydroxy group, an amino group, an amide group, a carbonyl group, a carboxyl group, a sulfo group, a phosphate group, an imidazole group and a guanidine group.

## Description

### TECHNICAL FIELD

The present invention relates to an orientation agent for NMR spectroscopy containing nanosheets that are self-orientable in a magnetic field and are coated with particular compound(s) such as proteins.

### BACKGROUND ART

As techniques for analyzing protein structures, analysis techniques such as those employing X-ray crystallography or nuclearmagnetic resonance (NMR) have been established heretofore.

X-ray crystallography (XRC) is a technique in which a crystalline target is irradiated with X-rays that cause diffraction phenomenon to be measured for predicting the 3-dimensional structure of proteins. This technique is applicable to a compound of significantly large molecules since a target to be measured is subjected to no limitations in molecular weight. Obviously, this technique cannot be applied to an incrystallizable sample. Also, the X-ray crystallography is unsuitable to the dynamic analysis of biomolecules since this technique originally aims at measuring static structures to the accuracy of atomic level.

Meanwhile, structural analysis using nuclearmagnetic resonance (NMR) requires no crystallization process, and can non-destructively obtain information about the kinetic properties and local structures around nuclear. Particularly, this technique can provide information not only on relative distances or orientations between atoms arranged in close vicinity with each other, but also on relative distances or orientations between atoms far apart from each other with reference to the external magnetic field by measuring anisotropy terms such as Residual Dipolar Coupling (RDC), nuclear quadrupole interaction and/or chemical shift. This can contribute to a more accurate 3D-analysis of the proteins.

Typically, measurement target molecules are in a random thermal motion in a solvent, and hence need to be magnetically oriented for measuring anisotropy terms such as Residual Dipolar Coupling (RDC). For that purpose, a medium having a property of orienting itself to a particular direction with reference to the static magnetic field (hereafter referred to as "orientation agent") may be concomitantly used to orient the measurement target molecules to certain directions to thereby improve the accuracy of the NMR spectroscopy.

As a commercially available orientation agent, there has been known a so-called "bicelle" which is a lipid aggregate of micelles having a lipid bilayered membrane with a shape of a disc (Patent document 1). Bicelles are made of phospholipids of long- and short- alkyl chains, and orient themselves to the static magnetic field due to the anisotropy of magnetic susceptibility that originates from P = O bonds. The oriented bicelles repeatedly interact with target molecules to thereby orient the target molecules with reference to the magnetic field.

An orientation agent employing a fibrous phage that is referred to as pf1 may also be publicly available (non-patent document 1).

### PRIOR ART DOCUMENT

### Patent document

Patent document 1: Japanese Unexamined Patent Application Publication No. 2001-89946

### Non-patent document

Non-patent document 1: Hansen MR, Mueller L, Pardi A.(1998) Nat Struct Biol Dec;5(12):1065-74

### SUMMARY OF THE INVENTION

### Problem to be solved by the invention

Unfortunately, if the bicelles are employed for orienting the target molecules, the bicelles need to be adjusted to have relatively high concentrations. As the bicelles are expensive in terms of cost per unit weight, it is economically unfavorable to use such a highly concentrated orientation agent employing bicelle. Further, the temperature of a solution containing the bicelles needs to be adjusted to a temperature in a limited range of about 30 to about 50 °C for the bicelles to be magnetically spontaneously oriented with the use of a magnetic field. That is, the orientation agent of bicelle is disadvantageous in that the agent is difficult to prepare. The orientation agent employing bicelle is also disadvantageous in that the orientation agent and/or the target molecules cannot be collected after use.

An orientation agent employing a fibrous phage (pf1) works well at a lower concentration but this agent is more expensive than the bicelle. Further, as the orientation agent employing fibrous phage cannot perform individual surface-modifications that are specifically tailored to target molecules, this agent is applicable only to a limited range of target molecules and thus has low versatility. Additionally, as the orientation agent employs a phage, this agent is disadvantageous in that the phage necessitates an appropriate biohazard measure in use.

Therefore, the object of the present invention is to solve the above-noted disadvantages in the prior arts, and to provide an orientation agent for NMR spectroscopy which is easy to prepare, excellent in handleability, economic efficiency and versatility, and is capable of being stably oriented to the magnetic field.

### Means of solving the problems

As a result of intensive researches by the present inventors aiming at overcoming the above-mentioned technical problems, the following nanosheet has been found to attain the object of the present invention. That is, the present invention is to provide the followings:
(1) An orientation agent for NMR spectroscopy comprising:
   a nanosheet; and
   a compound having a molecular weight of 1,500 or more and containing 35 or more functional groups per molecule, said functional groups being composed of at least one selected from a hydroxy group, an amino group, an amide group, a carbonyl group, a carboxyl group, a sulfo group, a phosphate group, an imidazole group and a guanidine group,
   wherein the nanosheet is coated with the compound.
(2) The orientation agent for NMR spectroscopy according to (1), wherein the nanosheet has a thickness of 0.5 to 3 nm and a size of 100 nm to 100 µm.
(3) The orientation agent for NMR spectroscopy according to (1) or (2), wherein the nanosheet is a nanosheet comprising at least one selected from titanium oxide, niobium oxide and graphene oxide.
(4) The orientation agent for NMR spectroscopy according to any one of (1) to (3), wherein the compound is at least one selected from proteins, tannic acid, poly(diallyldimethylamine chloride) and chondroitin sulfate.
(5) The orientation agent for NMR spectroscopy according to (4), wherein the proteins include at least one selected from casein, lysozyme and albumin.
(6) A titanium oxide nanosheet coated with at least one selected from proteins, tannic acid, poly(diallyldimethylamine chloride) and chondroitin sulfate.
(7) A niobium oxide nanosheet coated with casein.
(8) A graphene oxide nanosheet coated with casein.

### BRIEF DESCRIPTION OF THE DRAWINGS

FIG. 1 illustrates a schematic diagram of a nanosheet of titanium oxide.
FIGs. 2A and 2B illustrate schematic views of the nanosheets of titanium oxide that are magnetically oriented.
FIGs. 3A and 3B illustrate schematic views of magnetically oriented nanosheets of niobium oxide or graphene oxide.
FIG. 4 illustrates images of nanosheet-dispersed liquids.
FIG. 5 illustrates images of nanosheet-dispersed liquids in the presence of sodium chloride.
FIG. 6 illustrates a graph for Dynamic Light Scattering (DLS) showing the size distribution of the nanosheets with no coating agent.
FIGs. 7A and 7B illustrate graphs for Dynamic Light Scattering (DLS) showing the size distribution of the nanosheets.
FIGs 8A to 8C are Transmission Electron Microscope (TEM) images of nanosheets with no coating agent.
FIGs 9A to 9C are Transmission Electron Microscope (TEM) images of nanosheets that are coated with coating agents.
FIGs 10A to 10E are Atomic Force Microscope (AFM) images of nanosheets.
FIGs. 11A to 11D illustrate graphs showing correlations between the protein amounts used for preparing the nanosheets and the corresponding protein amounts adsorbed on the nanosheet.
FIGs. 12A and 12B show absorption spectra of nanosheets using CBB staining before or after coating the nanosheet with proteins.
FIGs. 13A and 13B illustrate graphs showing temporal changes of the protein adsorbed amounts.
FIGs. 14A to 14F are confocal laser microscope images of mixtures of nanosheets and fluorescent-labeled model compounds.
FIG. 15A illustrates a schematic view of the Small Angle X-Ray scattering (SAX) analysis of the nanosheets and FIGs. 15B to 15D are the resultant images of the Small Angle X-Ray scattering (SAX) analysis.
FIGs. 16A to 16F show split peaks originating from the quadrupole interactions of D₂O present in the dispersion liquid of nanosheet with no coating agent.
FIGs. 17A to 17H show split peaks originating from the quadrupole interaction of D₂O present in the dispersion liquid of nanosheet being coated with coating agent.
FIGs. 18A to 18C show ¹³C-NMR spectroscopy results for ¹³C labeled glucose.
FIGs 19A to 19G show IPAP-HSQC spectra of TiNS^{Cas} and NbNS^{Cas}.
FIGs. 20A to 20F summarize the RDC results calculated from the IPAP-HSQC spectrum analysis for TiNS^{Cas} and NbNS^{Cas}.
FIGs. 21A to 21E illustrate graphs each showing a correlation between the RDC calculated from the IPAP-HSQC spectrum analysis of TiNS^{Cas} and the RDC computed from the known structures.
FIG. 22 shows an SDS-PAGE result for a supernatant solution of TiNS^{Cas} or TiNS after centrifugation.

### MODE FOR CARRYING OUT THE INVENTION

### Nanosheet

As used herein, the term "nanosheet" refers to a sheet having a nanoscale thickness. The thickness of the nanosheet may be as thin as a thickness of one single atom but a nanosheet having a thickness of 0.5 nm or less is generally difficult to make. The nanosheet of the present invention preferably has a thickness of 0.5 to 3.0 nm, more preferably 1.0 to 2.5 nm, provided that the thickness of the nanosheet is exclusive of a coating agent to be described below. The nanosheet preferably has a thickness of 10 nm or smaller if the thickness includes the thickness of the coating agent. The thickness of the nanosheet as used herein refers to a value calculated from a cross-sectional profile at a given place observed by atomic force microscope (AFM).

The nanosheet of the present invention has a size preferably of 100 nm or more in favor of magnetic orientation property. It is preferred that the size of the nanosheet be as large as possible, provided that it is capable of being dispersed in the solution. However, the nanosheet has an actual upper limit of about 100 µm.

The size of the nanosheet as used herein is intended to refer to the breadth extended in the lateral directions, which is calculated as the particle diameter at which cumulative frequency for the particle radius is 50% of the frequent distribution, measured by the dynamic light scattering technique, with reference to the volume ratio.

Hence, the nanosheet typically has a size of a few micrometers, and has a thickness of a few nanometers where the aspect ratio of the thickness to the overall size is about 1:10³.

The present invention employs a nanosheet that exhibits anisotropic property in magnetic susceptibility to the external magnetic field. As the external magnetic field is applied to this type of nanosheet(s), the nanosheets orient themselves to the directions that are energetically most stable in such a way that the interaction potential of the nanosheets to the magnetic field takes minimum. This is because the magnetic susceptibility, or the extent to which the nanosheets are susceptible with respect to the magnetic field varies depending on the direction in which the magnetic field is applied thereto.

Such nanosheets may be prepared by any one of the known techniques. For example, a layered precursor may be exfoliated to provide nanosheets of large surface area. The resultant nanosheets of larger surface areas may exhibit more significant magnetic orientation property. The nanosheets of the present invention may orient small molecular particles such as water or glucose if uncoated nanosheets are solely used. Further, the nanosheets of the present invention may magnetically orient proteins of larger molecular weight in a solution if the nanosheets are coated with a coating agent such as proteins which will be described later in detail.

These nanosheets magnetically orient themselves when the sum of the magnetic anisotropies of the atoms composing the nanosheets outweighs their free movement in the solution. Each of the nanosheets theoretically orients itself, though the scales of the anisotropy are individually different from each other, irrespective of the composition or the type of the atom consisting the nanosheet if the nanosheet is sufficiently large, provided that all of the nanosheets consist of atoms having magnetic anisotropy. The nanosheet may be of any type or have any composition as long as the nanosheets exhibit magnetic orientation property. Such nanosheet may, for example, be of the followings:

Nanosheet of titanium oxide such as Ti_{0.91}O₂, Ti_{0.87}O₂, Ti₃O₇, Ti₄O₉, or Ti₅O₁₁; Nanosheet of niobium oxides such as Nb₃O₈, Nb₆O₁₇, or Ca₂Nb₃O₁₀;
graphene oxide;
graphene;
boron nitride (h-BN);
Graphitic Carbon Nitride (g-C₃N₄)
Nanosheet of polylactate, polythiophene or polystyrene or the like;
DNA (DNA origami);
Nanosheet of Metal Organic Framework (Molecular organic framework; MOF);
Nanosheet of Covalent Organic framework (COF)
Nanosheet of black phosphorus;
Nanosheet of peptoid; or
any other nanosheet of hydroxyapatite (Ca₅(PO₄)₃(OH)), NbS₃, NbSe₃, NbTe₃, Ti, Ti-Ni, Zn-Ti, Zn-Al, Pd, Co₉Se₈, TiS₃, TiSe₃, TiTe₃, TaS₃, TaSe₃, TaTe₃, MnPS₃, CdPS₃, NiPS₃, Mn_{0.5}Fe_{0.5}PS₃, MoCl₂, MoS₂, RuCl₂, CrCl₂, BiI₃, BiS₃, PbCl₄, V₂O₅, MoO₃, TaO₃, WO₃, HNbWO₆, HTaWO₆, HNb₃O₈, MnO₂, Naₓ(Mn⁴⁺,Mn³⁺)₂O₄, Sr₂RuO₄, KCa₂Nb₃O₁₀, H₂W₂O₇, LaNb₂O₇, La_{0.90}Eu_{0.05}Nb₂O₇, Eu_{0.56}Ta₂O₇, Sr₂RuO₄, Sr₃Ru₂O₇, SrTa₂O₇, Bi₂SrTa₂O₉, Sr₂Nb₃O₁₀, NaCaTa₃O₁₀, CaLaNb₂TiO₁₀, La₂Ti₂NbO₁₀, Ba₅Ta₄O₁₅, LaOCuCh (Ch: chalcogenide and the derivative thereof), Sr₂MO₂Cu_{2-δ}S₂ (M = Mn, Co, Ni), Sr₂MnO₂Cu_{2m-0.5}Sₘ₊₁ (m = 1-3), Sr₄Mn₃O_{7.5}, Cu₂Ch₂ (Ch=S, Se), LaOFeAs, VOCl, CrOCl, FeOCl, NbO₂F, WO₂Cl₂, FeMoO₄Cl, GaX (X = S, Se, Te), InX (X = S, Se, Te), CaHPO₄, Mⁿ⁺_{x/n}. yH₂O[Al₄₋ₓMgₓ](Si₈)O₂₀(OH)₄ (M: cation), [(Mg₃)(Si₂O₅)₂(OH)₂], [Mg₆Si₆Al₂O₂₀(OH)₄] [Mⁿ⁺_{1/n}] (Mg₆) (M: cation), [(MgFe)₃(Si₃Al)O₁₀(OH)₂]K, [(Mg₆)(Si₆Al₂)O₂₀(OH)₄]Ba, [Mg_{11/4}(Si₆Al₂)O₂₀F₄][(M²⁺)_{3/2}(M: cation), [(Al₂)(Si₂Al₂)O₁₀(OH)₂]Ca, [(Al₂)(Si₃Al)O₁₀(OH)₂]K, [Al₄Si₄O₁₀](OH)₈, Al₄Si₄O₁₀(OH)₈.4H₂O, (Mg²⁺ₓ, Mg³⁺ₓ(OH)₂ (Aⁿ⁻)_{x/n}. yH₂O) (A: anion), or Ti₃C₂.

Among the above-listed nanosheets, the nanosheets of titanium oxide, niobium oxide and graphene oxide are particularly favorable as the nanosheets of the present invention.

### Titanium oxide nanosheet

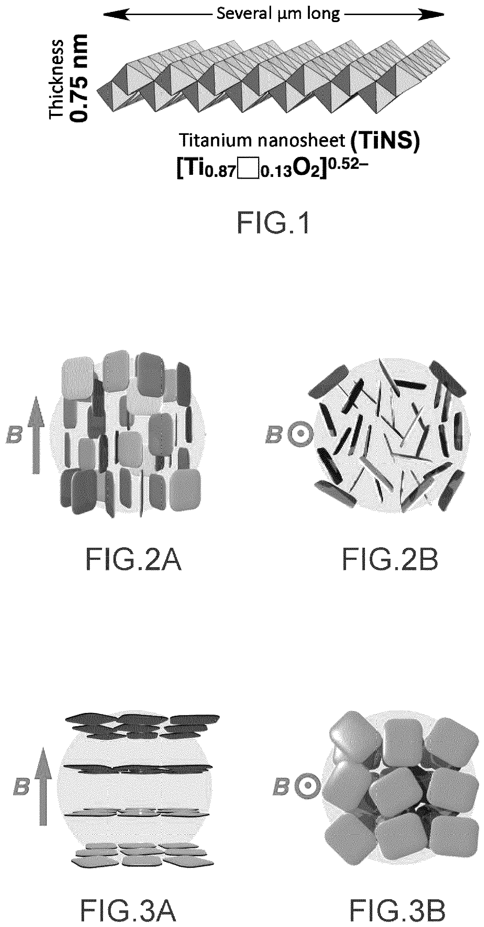

The titanium oxide nanosheet herein has a two-dimensional nanostructure which may be obtained by chemically treating the single crystal of layered titanate compound under a mild condition, and thus delaminating the single crystal one by one into individual single layers, each of them being an elemental unit of the crystal structure. The titanium oxide nanosheet has an exceptionally high aspect ratio. For example, the nanosheet having a crystalline structure of Ti_{0.87}□_{0.13}O₂(□: vacancy) has a thickness of about 0.75 nm and a width of several micrometers long (see FIG. 1). Such nanosheet has a magnetic orientation axis in the thickness direction and has a large surface area that is negatively charged at high density, which causes the sheets to be strongly and electrostatically repulsed from each other. For this reason, these nanosheets are excellent in dispersibility owing to the strong electrostatic repulsive forces exerted between the nanosheets, which allows a layered alignment of the nanosheets in the external magnetic field.

FIGs. 2A to 2B illustrate schematic views of the titanium oxide nanosheets that are magnetically oriented. FIG. 2A is a side view, and FIG. 2B is a top view. The symbol B represents the magnetic field where the arrow beside the symbol B and the encircled dot both indicate the direction of the magnetic field. The titanium oxide nanosheets orient themselves in such a way that the normal directions of the nanosheets are each in line with the direction of the external magnetic field. Also, as the large electrostatic repulsive forces are exerted between the nanosheets, all of the nanosheet surfaces face in the same direction to be co-facially oriented with each other. The nanosheets, therefore, possess a powerful orientation property.

### Niobium oxide nanosheet

FIGs. 3A to 3B illustrate schematic views of the niobium oxide nanosheets that are magnetically oriented. FIG. 3A is a side view and FIG. 3B is a top view. The symbol B represents the magnetic field where the arrow beside the symbol B and the encircled dot both indicate the direction of the magnetic field. The niobium oxide nanosheets orient themselves in such a way that the tangent directions of the nanosheets are each in line with the direction of the external magnetic field. For this reason, the nanosheets are each rotatable about the orientation axis of the nanosheet where the orientation axis is in line with the tangent direction of the sheet.

### Graphene oxide nanosheet

The graphene oxide nanosheets orient themselves in such a way that the tangent directions of the nanosheets are each in line with the direction of the external magnetic field as is the case of the niobium oxide nanosheet. For this reason, the nanosheets are each rotatable about the orientation axis of the nanosheet where the orientation axis is in line with the tangent direction of the sheet.

### Nanosheet coating agent

The nanosheet of the present invention may magnetically orient not only small molecules such as glucose but also proteins having larger molecular weight for implementing NMR spectroscopy when coated with a coating agent. The coating agent to be applied to the nanosheet surface may be selected based on the target molecules for the NMR spectroscopy to optimize the interaction between the nanosheet and the target molecules to thereby control the nonspecific adsorption of proteins (or target molecules). The coating of the coating agent allows the nanosheets to retain their dispersibility without being significantly affected by the presence of salts or pH.

The coating agent of the present invention is a water-soluble compound that may be physically adsorbed on the nanosheet in a multipoint manner. The above-noted coating agent is adsorbed on the nanosheet via interactions such as hydrogen-bonding and/or dipolar interaction. For that purpose, the coating agent of the present invention may be a compound containing 35 or more polar functional groups per molecule, where the polar functional groups are at least one selected from a hydroxy group, an amino group, an amide group, a carbonyl group, a carboxyl group, a sulfo group, a phosphate group, an imidazole group and a guanidine group, which are illustrated below:

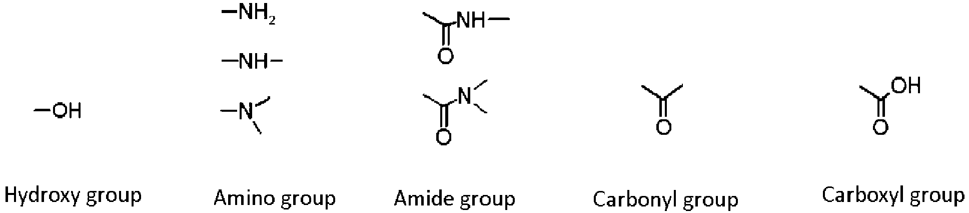

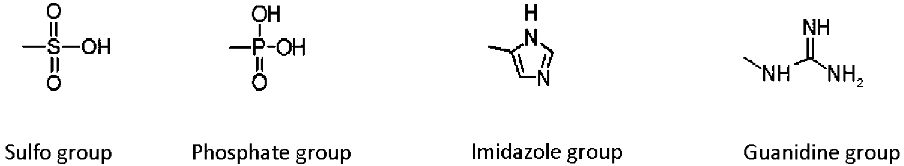

The number of the at least one functional group selected from a hydroxy group, an amino group, an amide group, a carbonyl group, a carboxyl group, a sulfo group, a phosphate group, an imidazole group and a guanidine group, in one molecule, is preferably 50 or more, more preferably 100 or more. The upper limit to the number of the functional groups may not particularly be limited but typically be about 100 to 1000 for the proteins as described below.

The number of the functional groups herein is counted as one functional unit for each of the above listed functional groups. For example, if a molecule of the coating agent contains an amide group, this amide group is not counted as one carbonyl group and one amino group but rather as one single functional group of one amide group.

Further to the number of the functional groups, the nanosheet coating agent of the present invention needs to have a molecular weight of 1,500 or more, preferably of 1,700 or more in order for the material to be physically adsorbed on the nanosheet to perform multi-point interaction. The molecular weight of the coating agent may appropriately be determined based on the type of coating agent. For example, when the coating agent is of a single component such as tannic acid, this molecular weight is defined as a chemical formula weight. When the coating agent is of a synthetic polymer compound such as that exemplified by poly (diallyldimethylamine chloride), the molecular weight of the compound is determined as an average molecular weight converted from the particle diameter at which cumulative frequency for the particle radius is 50% of the frequent distribution, measured by the dynamic light scattering technique, with reference to the volume ratio, into the molecular weight of the polyethylene glycol (PEG) having a comparative molecular weight. When the coating agent is of protein such as that exemplified by casein (to be described later), the molecular weight of such protein is determined as that calculated from the molecular structures of the known amino acid sequences.

The upper limit to the molecular weight of the coating agent may not particularly be limited but typically be about 10,000 to 100,000 for the proteins described below.

The coating agent, having said number of the functional groups and the molecular weight as noted above, includes a polymer compound consisting of a plurality of the following units that are linked with each other, where the compound may be of a natural polymer compound or a synthetic polymer compound.

Examples of these units of the coating agent may, for example, be amino acids such as arginine, histidine, alanine, glycine, serine, aspartic acid, lysine, glutamic acid, alanine, glutamine, methionine, phenylalanine, proline, isoleucine, leucine, cysteine, valine, tyrosine, tryptophan, threonine or asparagine.

The coating agent may be of a polyamino acid whose composition units involve any one of these amino acids, or of a polyamino acid whose composition units involve any two or more of these amino acids.

Examples of the polyamino acids that consist of any one of these amino acids as the composition unit may be polyarginine, polyhistidine, polyalanine, polyglycine, polyserine, polyaspartic acid, polylysine, polyglutamic acid, polyglutamine, polyglutamine, polymethionine, polyphenylalanine, polyproline, polyisoleucine, polyleucine, polycysteine, polycysteine, polyvaline, polytyrosine, polytryptophan, polythreonine, or polyasparagine.

Further, examples of the polyamino acids that consist of any two or more of these amino acids as the units may include casein, lysozyme, albumin, pepsin, ribonuclease, serum protein, protamine, concanavalin A, fibroblast growth factor (FGF), tumor necrosis factor (TNF), transforming growth factor (TGF), nerve growth factor (NGF), epithelium growth factor (EGF), insulin-like growth factor (IGF), brain-derived neurotrophic factor (BDNF), vascular endothelial growth factor (VEGF), granulocyte colony stimulating factor (G-CSF), granulocyte macrophage colony stimulating factor (GM-CSF), platelet derived growth factor (PDGF), erythropoietin (EPO), thrombopoietin (TPO), hepatocyte growth factor (HGF), bone morphogenetic protein (BMP), immunoglobulin, glucose oxidase, ovalbumin, lectin, ferritin , hemoglobin, myoglobin, trypsin , cytochrome c, collagen, gelatin, streptavidin, avidin, chaperonin, insulin, amyloid β, peroxidase, catalase, fluorescent protein (GFP, BFP, YFP, RFP), fibronectin, laminin, proteoglycan, tenascin, elastin, fibrillin, entactin, amylase , cellulase, alkaline phosphatase, esterase, or any other type of protein.

The coating agent may, for example, be of polyvinyl alcohol, polycatechol, polyacrylamide, poly (N-isopropylacrylamide), polydimethylacrylamide, polyamidoamine, polyvinyl pyrrolidone, polyacrylamido 2-methyl 1-propanesulfonic acid, polyurethane, polyurea, polythiourea, polyethylenimine, polyacrylic acid, polyallylamine, polystyrene sulfonic acid, polyvinyl sulfonic acid, poly (diallyldimethylamine chloride), polydimethylaminoethoxy methacrylate, polytrimethylamino ethoxy methacrylate hydrochloride, or polyanetole sulfonic acid.

These coating agents may be of a homopolymer or of a copolymer consisting any two or more of these monomers. If the coating agent is of a copolymer, the copolymer may have a monomer arrangement in any one of the random, block, and graft forms. Further, if these polymers are ionic electrolyte, the coating agent may include the salts of the polymers.

In addition, examples of the coating agents include sugar chains such as agarose, chitin, chitosan, alginic acid, hyaluronic acid, curdlan, pullulan, cellulose, gellan gum, dextran, cyclodextran, albinogalactan, starches, chondroitin sulfate, heparan sulfate, heparin, and pectin. If these sugar chains are ionic electrolyte, the coating agent may include the salts of the sugar chains.

Further, the coating agent may employ not only the polymer compound consisting of the plurality of the above described units that are linked with each other but also a compound having a large number of phenolic hydroxyl groups in one molecule such as tannic acid, provided that the compound contains the above-specified number of functional groups and the above-defined molecular weight.

Further, the nanosheet coating agent of the present invention may be a mixture containing at least any one of the compounds as set forth herein. The mixture contains the compounds by an amount of 2 to 99 wt%, preferably of 20 to 80 wt%. Examples of such mixture may include a skimmed milk and an ager.

The type of coating agent may appropriately be determined based on the target molecules for NMR spectroscopy. For example, if the target molecule is anionic, it is preferable that the nanosheets be coated with an anionic coating agent such as that of casein. Meanwhile, if the target molecule is cationic, it is preferable that the nanosheets be coated with a cationic coating agent such as that of lysozyme.

Regarding the selection of the coating agent, if a strong fluorescence is observed by using a confocal laser microscope after the nanosheets, coated with the coating agent, are mixed with fluorescence-labeled target molecules, it is determined that such material is not suitable as a coating agent. This indicates a presence of strong interaction between target molecules and the nanosheet coated with the coating agent, which thereby causes disturbance to the orientation behavior. Meanwhile, if a weak fluorescence is observed, this implies that the orientation behavior of the nanosheets coated with the coating agent is not being disrupted and that the nanosheets favorably orient themselves together with the target molecules. In that case, it is determined that such material is favorable as a coating agent.

### Preparation for nanosheet coated with coating agent.

Coating of the nanosheet may be performed as follows:
1. Nanosheets and a coating agent of an excessive amount as compared to the nanosheets are mixed in a proper solvent.
   Here, the type of the solvent to be used is properly selected based on the combination of the nanosheet and the coating agent. That is, the solvent is appropriately selected among those that are capable of dissolving or dispersing both of the nanosheets and the coating agent, and those that do not interact with either the nanosheets or the coating agent. For example, water, various types of buffer solution, tetramethylammonium (TMA), or tetrabutylammonium (TBA) may be used as such solvent. A coating agent in an amount 5 times greater by weight than the amount of nanosheet or in an amount even greater than said amount would be sufficiently qualified as the excessive amount of coating agent.
2. The prepared solution mixture of the coating agent and the nanosheet is allowed to stand still for a predetermined time.
   The predetermined time is appropriately determined based on the combination of the two i.e. the interaction strength between the coating agent and the nanosheet, but the predetermined time is typically about few minutes to 60 minutes.
3. The standing solution mixture is centrifuged to remove the un-adsorbed coating agent.

If necessary, the precipitate obtained after centrifugation may be re-dispersed in an appropriate solvent, and may also be subjected to cleaning repetitively by centrifugation and re-dispersion. The centrifugation condition depends on the type of the nanosheet and the coating agent, but typically is 15,000 rpm for 15 minutes at 4 °C.

All the documents referred to in the present specification are incorporated herein by reference in their entirety.

### WORKING EXAMPLE

The embodiments of the present invention described below are for illustrative purposes only and do not limit the technical scope of the present invention. The technical scope of the present invention is limited only by the claims. Modifications of the present invention, such as, additions, deletions, and replacements of the constituent features of the present invention can be made without departing from the spirit of the present invention.

### Materials and Methods

The following coating agents were used:
Casein: Commercial product (Wako Pure Chemical Industries, Ltd)
Albumin: Commercial product (Wako Pure Chemical Industries, Ltd)
Lysozyme: Commercial product (Wako Pure Chemical Industries, Ltd)
Skim milk: Commercial product (Wako Pure Chemical Industries, Ltd; a material containing 27 wt% of casein)
Tannic acid: Commercial product (Aldrich Co. LLC)
Poly(diallyldimethylamine chloride): Commercial product (Aldrich Co. LLC; average molecular weight: 36,000; the number of polar functional groups: 222 per molecule)
Chondroitin sulfate: Commercial product (Wako Pure Chemical Industries, Ltd; average molecular weight:144,000; the number of polar functional groups: 1787 per molecule)
PEG-modified catechol: the following method was used for the synthesization:

### Synthesizing method of PEG-modified catechol

0.025 mmol of PEG-NHS (molecular weight: 10,000 g/mol, SUNBRIGHT) and 0.040 mmol of catechol (Tokyo Chemical Industry Co., Ltd) were reacted overnight in dimethylformamide (DMF) in the presence of 0.070 mmol of 4-N methyl morpholine. After that, unreacted molecules were removed by dialysis treatment to obtain a reaction product as a PEG-modified catechol (Average molecular weight: 10, 153, the number of polar functional groups: 3 per molecule) represented by the following formula. The molecular weight of PEG-NHS was determined in terms of PEG by gel permeation chromatography (GPC).

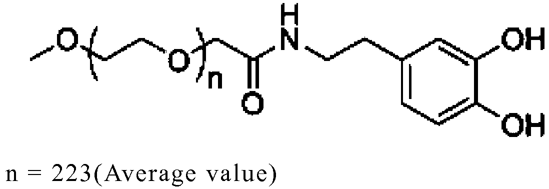

The casein as used herein is that prepared, with reference to a previous report (Tomishige M, Vale RD.(1998) J Cell Biol 151:1081-92), by base-treating a commercially available casein with sodium hydrate overnight, followed by centrifuging the same to remove the precipitate.

As for the coating agents other than casein, commercially available products were used as they were.

Regarding the molecular weight of poly(diallyldimethylamine chloride), the dynamic light scattering (DLS) method gave an average particle diameter of 4.17 nm, which was converted into the molecular weight of the PEG, having the particle diameter comparable with the average diameter thereof, to calculate the converted molecular weight of the poly(diallyldimethylamine chloride).

Similarly, regarding the molecular weight of chondroitin sulfate, the dynamic light scattering (DLS) gave an average particle diameter of 6.61 nm, which was converted into the molecular weight of the PEG, having the particle diameter comparable with the average diameter thereof, to calculate the converted molecular weight of the chondroitin sulfate.

### Nanosheet size determination by dynamic light scattering (DLS)

Apparatus: Zetasizer Nano ZSP (Trade name) by Malvern Panalytical
Measuring condition: room temperature
Material: a nanosheet-dispersed liquid containing 0.008 wt% of titanium oxide nanosheet was used for the measurement.

### Nanosheet observation by Transmission Electron Microscope (TEM)

Apparatus: JEM-1230 (Trade name) by JEOL
Measuring condition: Room temperature under vacuum
Material: A nanosheet-dispersed liquid containing 0.008 wt% of titanium oxide nanosheet was used for the measurement.

### Nanosheet observation by Atomic Force Microscope (AFM)

Apparatus: CypherS (Trade name) by Asylum Research
Measuring condition: Room temperature

### Zeta potential measurement

Apparatus: Zetasizer Nano ZSP (Trade name) by Malvern Panalytical
Measuring condition: Room temperature
Material: A nanosheet-dispersed liquid containing 0.008 wt% of titanium oxide nanosheet was used for the measurement.

### Small Angle X-ray scattering(SAX)

Apparatus: BL45XU in SPring-8
Material: A nanosheet-dispersed liquid containing 0.4 wt% of titanium oxide nanosheet was immobilized by hydrogelation while being magnetically oriented , and then used for mesurment.

### Nuclear Magnetic Resonance (NMR) spectroscopy

Apparatus: JNM-ECA-500 (Tradename) by JEOL
Measuring condition: 0 to 90 °C; Quadrupole interaction measurement for deuterium water using nanosheets
Material: A nanosheet-dispersed liquid containing 0.1 to 3.0 wt% of titanium oxide nanosheet was used for the measurement.
Apparatus: ACANCE-500 (Tradename) by Bruker
Measuring condition: 0 to 50 °C; HSQC analysis for ¹H-¹⁵N in protein
Material: A nanosheet-dispersed liquid, containing 1.5 wt% of titanium oxide nanosheet and a 15N labeled GB1 protein (4 mg/mL), was used for the measurement.
Apparatus: ACANCE-600 (Tradename) by Bruker
Measuring condition: 65 to 80 °C; HSQC analysis for ¹H-¹⁵N in protein
Material: a nanosheet-dispersed liquid, containing 1.5 wt% of titanium oxide nanosheet and a ¹⁵N labeled GB1 protein (4 mg/mL), was used for the measurement.

### Nanosheet preparation

The nanosheets as used herein in the reference examples, working examples and comparative example are listed in Table 1. Methods for preparing each of the exemplified nanosheets will be described below.

**[Table 1]**

| Reference example | | Nanosheet | Coating agent |
|---|---|---|---|
| 1 | TiNS | TiNS | None |
| 2 | ^{small}TiNS | ^{small}TiNS | None |
| 3 | NbNS | NbNS | None |

| Working example | | Nanosheet | Coating agent |
|---|---|---|---|
| 1 | TiNS^{Cas} | TiNS | Casein (Cas) |
| 2 | TiNS^{Alb} | | Albumin (Alb) |
| 3 | TiNS^{Lys} | | Lysozyme (Lys) |
| 4 | TiNS^{Skim} | | Skim milk (Skim) |
| 5 | TiNS^{Tan} | | Tannic acid (Tan) |
| 6 | TiNS^{PDDA} | | Poly(diallyldimethylamine chloride) (PDDA) |
| 7 | TiNS^{Cho} | | Chondroitin sulfate (Cho) |
| 8 | NbNS^{Cas} | NbNS | Casein (Cas) |
| 9 | GONS^{Cas} | GONS | Casein (Cas) |

| Comparative example | | Nanosheet | Coating agent |
|---|---|---|---|
| 1 | TiNS^{Cate} | TiNS | PEG-modified catechol (Cate) |

### Reference example 1: TiNS preparation

A titanium oxide nanosheet (composition: Ti_{0.87}O₂; herein denoted as "TiNS") was prepared in accordance with a previous report (Tanaka T, Ebina Y, Takada K, Kurashima K, Sasaki T.(2003) Chem Mater;15:3564-3568). In the following, unless otherwise specified, TiNS was dispersed in the tetramethylammonium (TMA) solution (1 mM) before various measurements.

### Reference example 2: ^{small}TiNS preparation

TiNS prepared in reference example 1 underwent ultrasonication for 3 minutes using a sonicator (Trade name: XL-2000 MicrosonTM; by Qsonica) to prepare a titanium oxide nanosheet (herein denoted as "^{small}TiNS"). In the following, unless otherwise specified, "^{small}TiNS" was dispersed in the tetramethylammonium solution (TMA; 1 mM) before various measurements.

### Reference example 3: NbNS preparation

A niobium oxide nanosheet (composition: Ca₂Nb₃O₁₀; herein denoted as "NbNS") was prepared in accordance with a previous report (Schaak RE, Mallouk T.(2002) Chem Mater 14:1455-1471). In the following, unless otherwise specified, "NbNS" was used in a manner dispersed in the tetrabutylammonium solution (TBA; 1 mM) before various measurements.

### Working example 1: TiNS^{Cas} preparation

A mixture of 500 µL of Tris-hydrochloride buffer solution (1 mM; pH: 8.0) containing 2.0 wt% of casein and 500 µL of aqueous solution containing 0.4 wt% of TiNS as exemplified in Reference example 1 was prepared. The mixture solution was allowed to stand still for 60 minutes before the mixture undertook ultrasonication for 10 seconds.

The mixture was centrifuged (15,000 rpm) for 15 minutes at 4 °C by using a centrifugal machine (Tradename: CT15RE by HITACHI) to remove the un-adsorbed casein.

The resultant precipitate was redispersed in 1 mL of Tris-hydrochloride buffer solution (1 mM; pH: 7.7). The cleaning operation of centrifugation and re-dispersion was carried out 3 times before the final precipitate is dispersed in 500 µL of Tris-hydrochloride buffer solution (1 mM; pH: 7.7) to obtain a dispersion liquid of casein-coated titanium nanosheet (TiNS^{Cas}). Here, the concentration of TiNS^{Cas} in the dispersion liquid was adjusted to an optimum concentration for various measurements by adjusting the amount of buffer solution in which the final precipitate is dispersed. Note that TiNS^{Cas} used for various measurements were those dispersed in the buffer solution for the re-dispersion unless otherwise specified.

### Working example 2: TiNS^{Alb} preparation

A dispersion liquid of albumin-coated titanium nanosheet (TiNS^{Alb}) was obtained by using a method similar to that illustrated in Working example 1 except that 2.0 wt% of albumin was used instead of 2.0 wt% of casein.

### Working example 3: TiNS^{Lys} preparation

A mixture of 500 µL of tetramethylammonium (TMA) solution (2 mM) containing 2.0 wt% of lysozyme and 500 µL of aqueous solution containing 0.1 wt% of TiNS as exemplified in Reference example 1 was prepared. The mixture was allowed to stand still for 60 minutes before removing the un-adsorbed lysozyme by centrifugation in a manner similar to that as performed in Working example 1. The precipitate was dispersed in 500 µL of Tris-hydrochloride buffer solution (1 mM, pH: 2.3) to obtain a dispersion liquid of lysozyme-coated titanium nanosheet (TiNS^{Lys}).

### Working example 4: TiNS^{Skim} preparation

A dispersion liquid of skim milk-coated titanium nanosheet (TiNS^{skim}) was obtained by using a method similar to that illustrated in Working example 1 except that 2.0 wt% of skim milk was used instead of 2.0 wt% of casein.

### Working example 5: TiNS^{Tan} preparation

A mixture of 1 mL of aqueous solution containing 0.85 wt% of tannic acid and 4 mL of aqueous solution containing 0.5 wt% of TiNS as exemplified in Reference example 1 was prepared. The mixture was allowed to stand still for 5 minutes before performing a cleaning operation, similar to that performed in Working example 1, 10 times by using pure water as a re-dispersing aqueous solution, thereby obtaining a dispersion liquid of the tannic acid-coated titanium nanosheet (TiNS^{Tan}).

### Working example 6: TiNS^{PDDA} preparation

A mixture of 1 mL of aqueous solution containing 0.1 wt% of poly(diallyldimethylamine chloride)(PDDA) and 1 mL of aqueous solution containing 0.02 wt% of TiNS as exemplified in Reference example 1 was prepared. The mixture was allowed to stand still for 60 minutes before removing the un-adsorbed PDDA by centrifugation in a manner similar to that as performed in Working example 3 to disperse the precipitate in 500 µL of Tris-hydrochloride buffer solution (1 mM; pH: 2.3), thereby obtaining a dispersion liquid of PDDA-coated titanium nanosheet (TiNS^{PDDA}).

### Working example 7: TiNS^{cho} preparation

A mixture of 1 mL of aqueous solution containing 0.2 wt% of chondroitin sulfate(Cho) and 1 mL of aqueous solution containing 0.01 wt% of TiNS as exemplified in Reference example 1 was prepared. The mixture was allowed to stand still for 60 minutes before performing a cleaning operation, similar to that as performed in Working example 1, three times by using pure water as a re-dispersing solution to obtain a dispersion aqueous solution of chondroitin sulfate-coated titanium nanosheet (TiNS^{Tan}).

### Working example 8: NbNS^{Cas} preparation

A dispersion liquid of casein-coated niobium nanosheet (NbNS^{Cas}) was obtained by using a method similar to Working example 1 except that NbNS as outlined in Reference example 3 was used instead of TiNS as outlined in Reference example 1.

### Working example 9: GONS^{Cas} preparation

A dispersion liquid of casein-coated graphene oxide nanosheet (GONS^{Cas}) was obtained by using a method similar to that illustrated in Working example 1 except that GONS(Trade name: Rap eGO(TQ11); NiSiNa material) was used instead of TiNS as outlined in Reference example 1.

### Comparative example 1: TiNS^{Cate} preparation

A mixture of 1 mL of aqueous solution containing 0.2 wt% of PEG-modified catechol and 1 mL of aqueous solution containing 0.8 wt% of TiNS as exemplified in Reference example 1 was prepared. The mixture was allowed to stand still for 60 minutes before performing a cleaning operation, similar to that as performed in Working example 1, 10 times to obtain a dispersion aqueous solution of PEG-modified catechol-coated titanium nanosheet (TiNS^{Cate}).

### STRUCTURE EVALUATION OF NANOSHEET

### (1) Observation of dispersion liquid

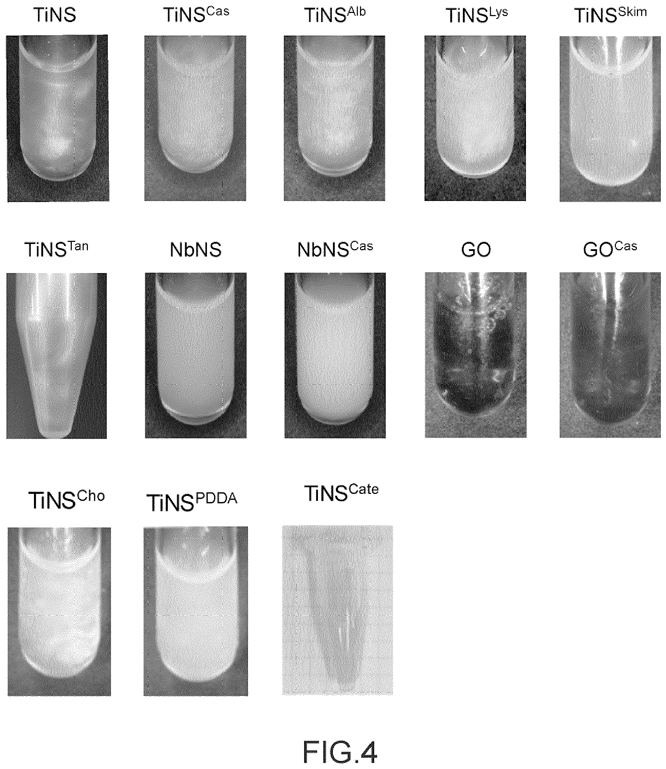

The images of the nanosheet-dispersed liquids as obtained in each of the examples are shown in FIG. 4. It was visually confirmed that all of the nanosheets in these examples were dispersed in the liquid. In addition, as for the TiNS dispersed liquids, a characteristic smoke-like texture originating from the TiNS domain structures was also confirmed in each of the dispersion liquids after being coated.

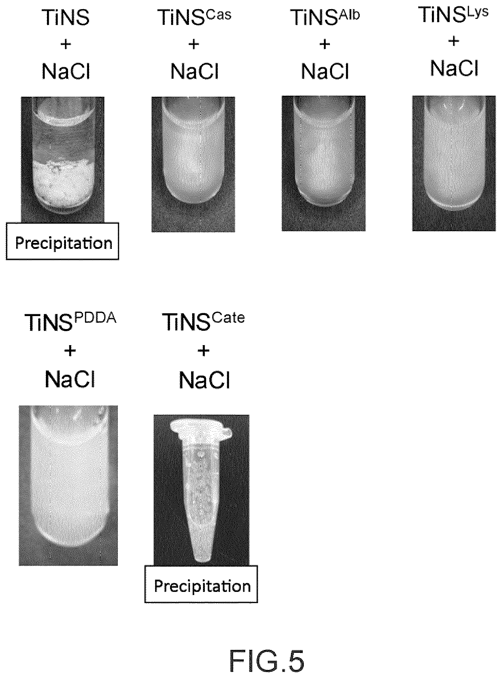

Further, 500 µL of solution of TiNS, TiNS^{Cas}, TiNS^{Alb}, TiNS^{Lys} or TiNS^{Cate} (respectively 0.8 wt% nanosheets) and 500 µL of sodium chloride aqueous solution (20 mM) were mixed to examine the influence of salt concentration in the nanosheet-dispersed liquids. FIG. 5 shows pictures of the nanosheet-dispersed liquids after adding sodium chloride aqueous solution.

Nanosheet precipitation was confirmed for TiNS with no coating agent. It was also confirmed that the nanosheets coated with coating agents were capable of maintaining nanosheet dispersibility even in the presence of salts whereas TiNS^{Cate} of Comparative example 1 caused precipitation in the presence of salts. This signifies the importance of multipoint interaction between the coating agent and the nanosheet.

As the nanosheets coated with the coating agent of the present invention are stably dispersed in the presence of salts, it is expected that the coated nanosheets be utilized as an orientation agent for solution NMR spectroscopy of proteins.

As noted, it was visually confirmed that the nanosheets of the working examples were dispersed. Further, various structural analyses were performed for the exemplified nanosheets.

### (2) Size estimation by Dynamic Light Scattering (DLS)

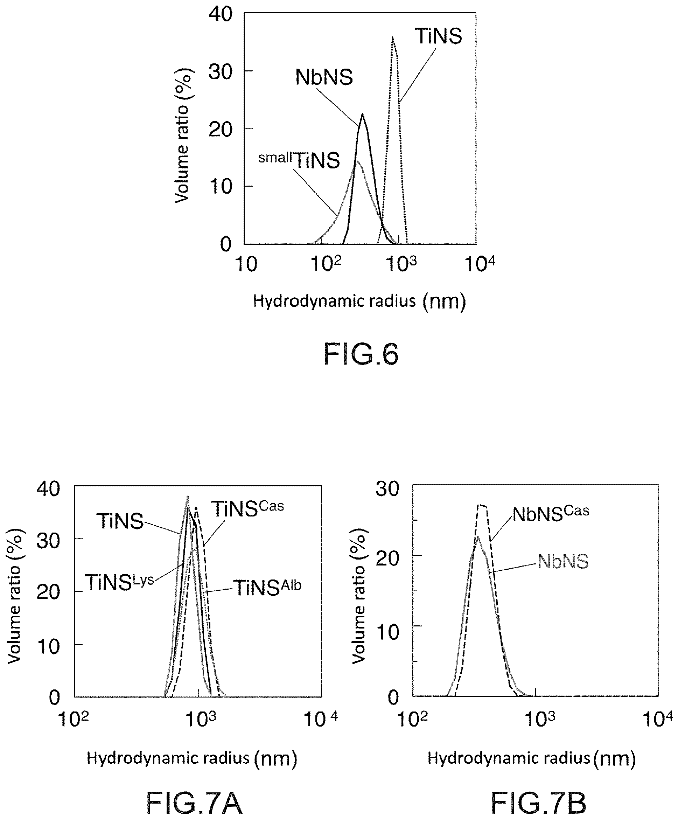

FIG. 6 shows size distributions as estimated by DLS for each of the un-coated nanosheets. The sizes for TiNS, ^{small}TiNS, and NbNS estimated by DLS were 825 nm, 295 nm, and 325 nm, respectively.

FIGs. 7A and 7B show size distributions before and after coating the same with the coating agents. A slight increase in size was observed with each of the TiNS and NbNS nanosheets that were coated with the coating agents. It was hence suggested that the nanosheets were coated by the coating agents. It was also confirmed that the nanosheets coated with the coating agents were dispersed in the solutions as were the cases with the nanosheets with no coating agent.

### (3) Observation of nanosheet-dispersed liquids by Transmission Electron Microscope (TEM)

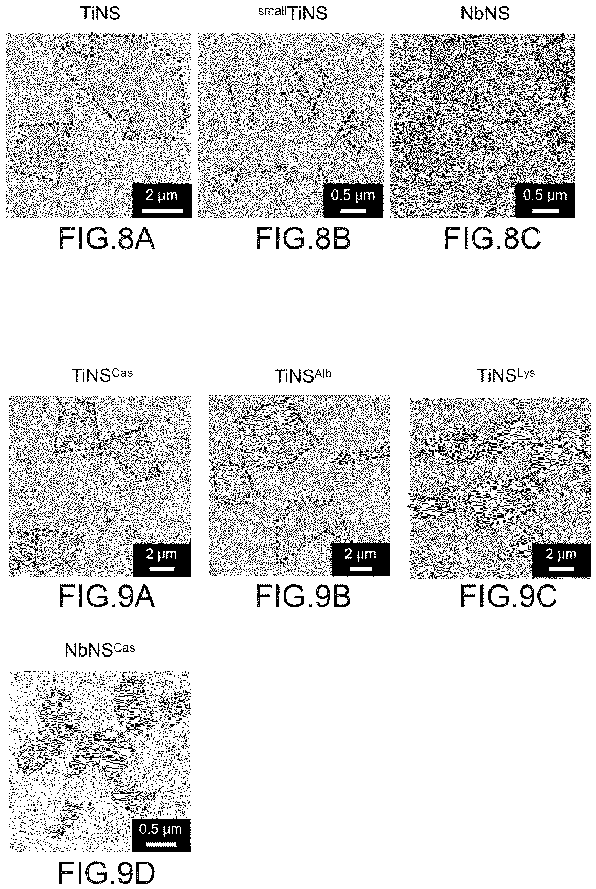

FIGs. 8A to 8C each shows a TEM image of nanosheets with no coating agent while FIGs. 9A to 9D each shows a TEM image of nanosheets being coated with coating agents. The dotted line in each of the TEM images is for highlighting the contours of the nanosheets.

Each of the nanosheets was dispersed without exhibiting any aggreation, and their sizes were consistent with the estimated values by DLS.

### (4) Observation by Atomic Force Microscope (AFM) and average thickness calculation of nanosheet

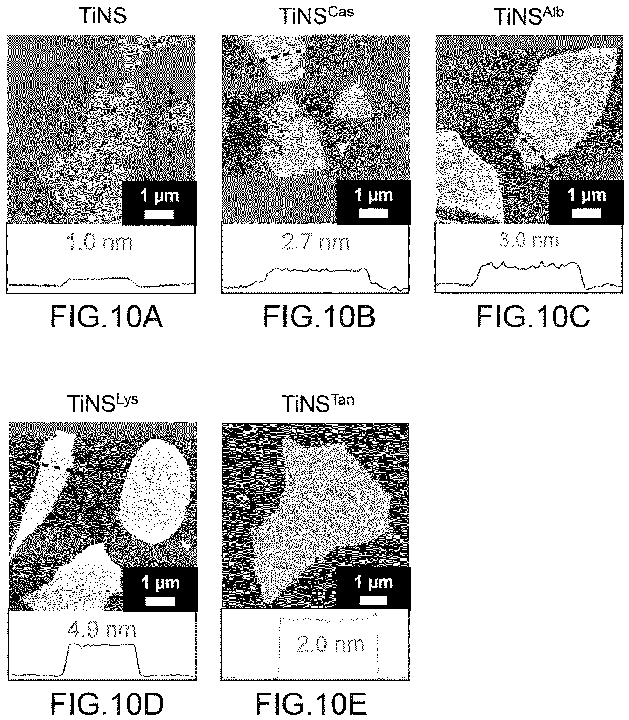

FIGs. 10A to 10E show AFM images of TiNS. The average thicknesses of the nanosheets were calculated from the cross-sectional profiles along the dotted lines in the AFM images. The nanosheets showed about 1.0 to 5.0 nm increase in thickness after being coated with the coating agents as compared to those with no coating agent. This strongly suggests the presence of coating agents being adsorbed on the surface of TiNS.

### (5) Zeta potential measurement

Zeta potentials of the nanosheet-dispersed liquids, as summarized in the working examples below, were measured. Table 2 shows the results thereof.

**[Table 2]**

| Working example | | Coating agent | Dispersion liquid | Zeta potential (mV) |
|---|---|---|---|---|
| 1 | TiNS ^{Cas} | Casein (Cas) | Tris hydrochloride buffer (1mM; pH:7.7) | -43.6 |
| 3 | TiNS ^{Lys} | Lysozyme (Lys) | Tris hydrochloride buffer (1mM; pH:2.3) | +50.1 |
| 6 | TiNS ^{PDDA} | Poly(diallyldimethylamine chloride) (PDDA) | Tris hydrochloride buffer (1mM; pH:2.3) | +55.1 |
| 7 | TiNS ^{cho} | Chondroitin sulfate (Cho) | Tetramethylammonium (1mM) | -70.9 |

The zeta potential for TiNS^{Cas} was found to be -43.6mV, which suggests that the casein as an anionic protein was adsorbed on the surface of the nanosheets. Meanwhile, the zeta potential for TiNS^{Lys} was found to be +50.1mV, which suggests that the lysozyme as a cationic protein was adsorbed on the surface of the nanosheets.

Likewise, the results for zeta potential measurements suggest that poly(diallyldimethylamine chloride) as a cationic polymer had been adsorbed on the surface of TiNS^{PDDA} and that chondroitin sulfate as an anionic compound had been adsorbed on the surface of TiNS^{cho}.

As shown in the above structural analyses, it was suggested that the coating agents were adsorbed on the surface of the nanosheets. Further, the amount of protein coating agent that had been adsorbed on the nanosheets was quantitatively assessed by using Coomassie Brilliant Blue (CBB).

### ADSORPTION EVALUATION OF COATING AGENT

### (6) Coating agent adsorption observation

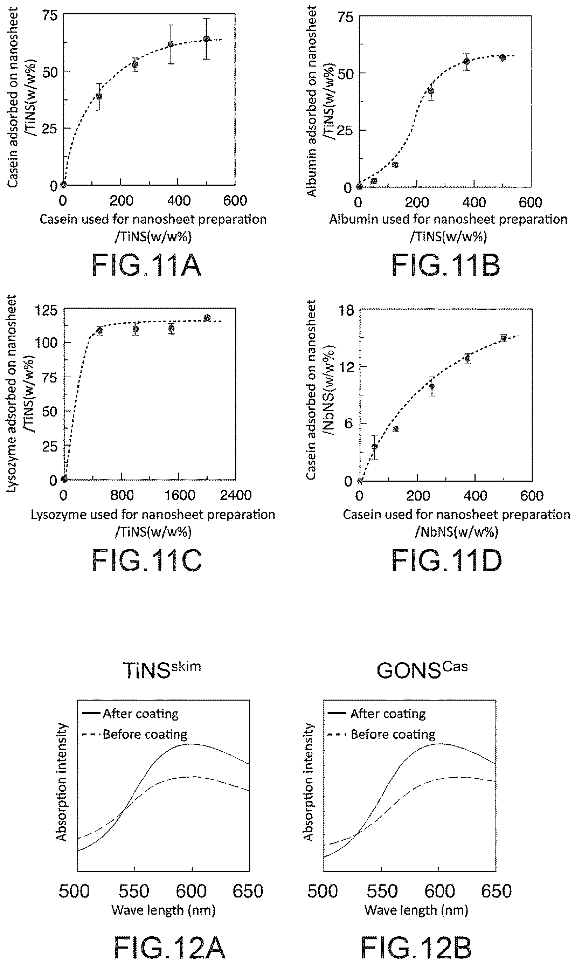

As for the nanosheet in which protein is used as a coating agent, the adsorbed amount of protein after coating was determined quantitatively by using CBB staining, where the nanosheets were prepared in each case by using different amounts of coating protein (0 to 2.0 mg/mL). The obtained results are shown in FIGs. 11A to 11D.

As the adsorption amount on the nanosheet was saturated for each of the proteins, it proved that that the whole surfaces of the nanosheets were fully coated by protein. The nanosheets, made by the preparation method as exemplified in the working examples, were prepared by using the coating agent in an amount of more than the saturation amount confirmed by the present experiment.

Further, CBB staining was performed in a similar manner for both TiNS^{Skim} and GONS^{Cas} to examine the protein adsorption. The obtained results are shown in FIGs. 12A and 12B. The results each showed an absorption peak around 585 nm that originated from CBB adsorbed on the proteins. It was thus confirmed that the protein was adsorbed on both TiNS and GONS.

Temporal variation in the amount of protein being adsorbed on the nanosheets was examined by using the following method to see if the proteins had been stably adsorbed over time on the nanosheets.

First, TiNS^{Cas} (0.7 wt%) was dispersed in Tris-hydrochloride buffer solution (1 mM; pH: 7.7) and the dispersion liquid was allowed to stand still under room temperature. The dispersion liquids that were allowed to stand still for 0.5, 1, 2, and 5 days from the production of the nanosheets were each centrifuged (15,000 rpm) for 15 minutes at 4 °C by using a centrifugal machine (Tradename: CT15RE by HITACHI). The protein contained in the supernatant solution was determined quantitatively by CBB staining.

The amount of protein adsorbed on the nanosheet was estimated as a ratio determined by subtracting the dissociated amounts of protein, having being dissociated from the nanosheets that are allowed to stand still respectively for 0.5, 1, 2 and 5 days, from the amount of protein adsorbed on the nanosheets immediately after the nanosheet preparation where the amount of protein adsorbed thereon immediately after the nanosheet preparation was defined as 100 % and the dissociated amount of protein immediately after the nanosheet preparation was defined as 0%. The dissociated amount of protein was estimated from the amount of protein contained in the supernatant solution.

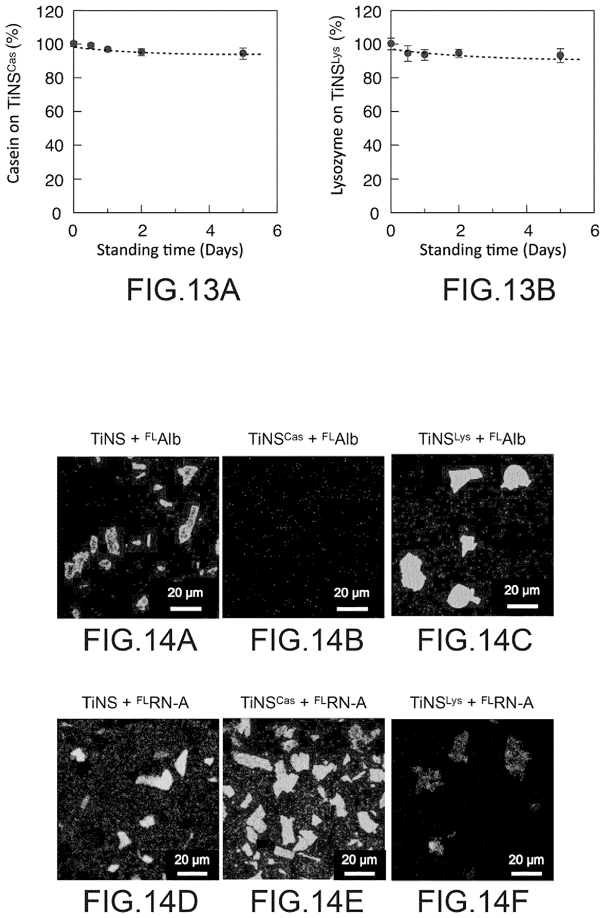

Similarly, the adsorbed ratio of protein on the nanosheet for TiNS^{Lys}(0.9 wt%) in Tris-hydrochloride buffer solution (1 mM; pH: 2.3) was also estimated. The results are shown in FIGs. 13A to 13B.

It was confirmed that both Cas and Lys were rarely dissociated from TiNS even after 5 days.

A fluorescence-labeled protein was utilized as a model compound. The model compound was mixed with the nanosheet-dispersed liquid and allowed to stand still. The nanosheet dispersed liquid was then observed by using a confocal laser microscope (CLSM) for identifying the interaction between the nanosheet and the model compound.

As for the model compound, a fluorescence-labeled albumin (^{FL}Alb) was used as an anionic protein and a fluorescence-labeled ribonuclease A (^{Fl}RN-A) was used as a cationic protein.

The ^{FL}Alb (0.5 mg/mL) was mixed with TiNS (0.4 wt% nanosheet concentration) in Tris-hydrochloride buffer solution (1 mM; pH: 7.7). CLSM images of the nanosheet-dispersed liquids after 24 hours were shown in FIG. 14A. FIG. 14B shows a result in which TiNS^{Cas} in Tris-hydrochloride buffer solution (1 mM; pH: 7.7) was used as a nanosheet, and FIG. 14C shows a result in which TiNS^{Lys} in Tris-hydrochloride buffer solution (1 mM; pH: 2.3) was used.

Likewise, FIGs. 14D to 14F show the results in which ^{Fl}RN-A(0.5 mg/mL) was used to be mixed with TiNS, TiNS^{Cas} or TiNS^{Lys}, respectively. FIGs. 14B and 14F exhibit the results of low fluorescence intensity. It was revealed that the adsorption of anionic ^{FL}Alb onto the negatively charged TiNS^{Cas} had been significantly suppressed and that the adsorption of cationic ^{Fl}RN-A onto the positively charged TiNS^{Cas} had been significantly suppressed.

It is not favorable for the NMR spectroscopy target molecules to have strong interaction with nanosheets because it interrupts their orientation property. For that reason, regarding the selection of the nanosheets and NMR spectroscopy target molecules, it is favorable to select a combination that exhibits low fluorescence intensity such as those shown in FIGs. 14B or 14F.

### EVALUATION ON MAGNETIC FIELD ORIENTATION PROPERTY

### (7) Small angle X-ray scattering (SAX)

TiNS^{Cas}, TiNS^{Alb}, and TiNS^{Lys} (respectively 0.4 wt%) were embedded in dimethylacrylamide gel before performing SAX analysis for examining magnetic field orientation property of the nanosheets coated with the coating agents.

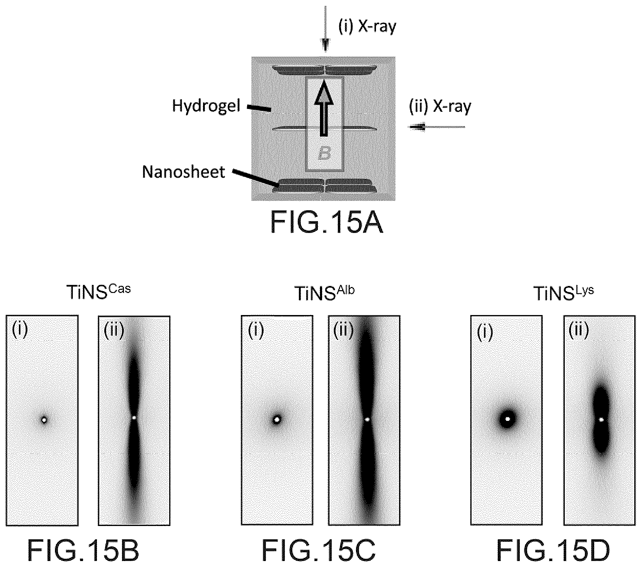

FIG. 15A illustrates a schematic view showing the outline of the examination where the symbol B represents the magnetic field vector. The SAX analysis results, as shown in FIGs. 15B to 15D, indicated that the protein-coated nanosheets were perpendicularly oriented to the magnetic field as were the cases with TiNS with no coating agent.

### (8) Orientation property evaluation from split peaks of D₂O quadrupole interaction

Magnetic orientation property of the nanosheets, according to the present invention, was first evaluated by water as being small molecule from the split peak width for the quadrupole splitting of water. The larger the peak width is, the more stronglty water molecules are oriented, which indiciates strong orientation property.

First, nanosheet concentration dependency for nanosheets with no coating agents was examined using different nanosheet concentrations in the testing samples while keeping the measurement temperature constant at 24 °C. Then, temperature dependency of the same was examined using different measurement temperatures for the measurement while keeping the nanosheet concentration in the testing samples constant.

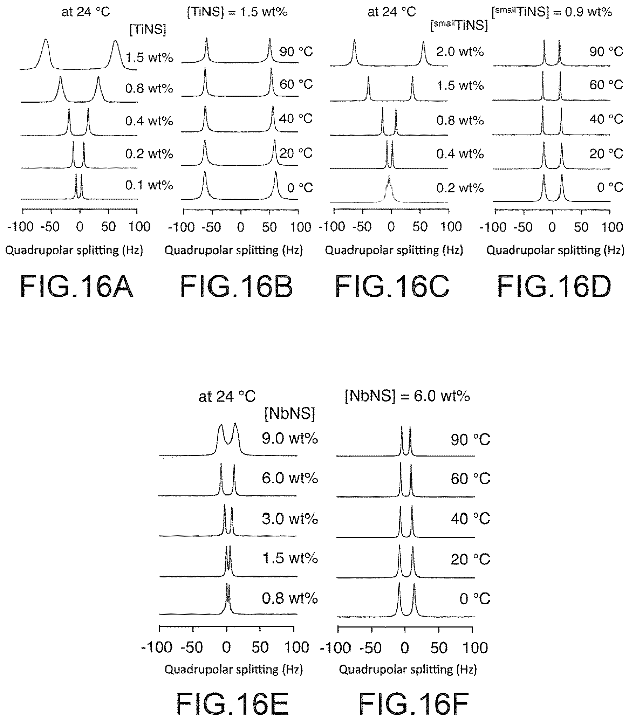

FIGs. 16A to 16F show the split peaks for D₂O quadrupole interaction in solutions as summarized in table 3.

**[Table 3]**

| Reference example | Nanosheet | Solvent |
|---|---|---|
| 1 | TiNS | Tetramethylammonium (TMA)(1mM) |
| 2 | ^{small}TiNS | Tetramethylammonium (TMA)(1mM) |
| 3 | NbNS | Tetrabutylammonium (TBA)(1mM) |

No split peaks were found for the reported bicelle (Shapiro RA, Brindley AJ, Martin RW.(2010) J Am Chem Soc 132:11406-11407) in a condition under 22 °C temperature, while the nanosheet of the present invention exhibited the corresponding split peaks under this condition, revealing that the nanosheets and water molecules were both oriented in the magnetic field.

Moreover, as the split peak width for D₂O quadrupole interaction becomes wider with the increasing concentration of nanosheet, it was found that the orientation property of the nanosheet gets higher in accordance with the nanosheet concentration. Further, it was found that the nanosheets have stable orientation property with respect to temperature since split peaks that correspond to D₂O quadrupole interaction were found in a wide range of temperature ranging from 0 to 90 °C substantially without being affected by the measuring temperature.

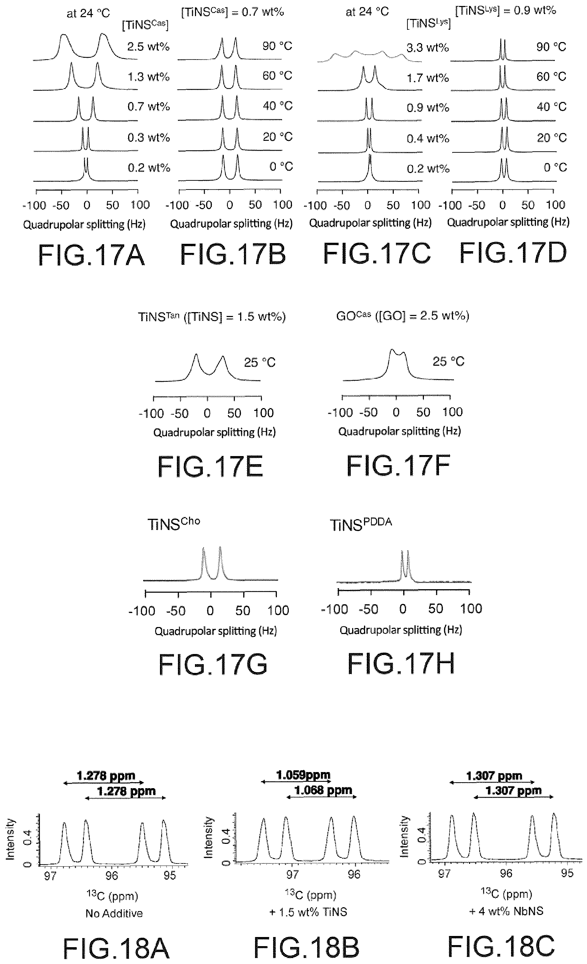

FIGs. 17A to 17H show split peaks for D₂O quadrupole interaction in the solutions as listed in Table 4 for the respective nanosheets that are coated with the corresponding coating agents.

**[Table 4]**

| Working example | Nanosheet | Solvent |
|---|---|---|
| 1 | TiNS^{Cas} | Tris hydrochloride buffer (1mM; pH:7.7) |
| 3 | TiNS^{Lys} | Tris hydrochloride buffer (1mM; pH:2.3) |
| 5 | TiNS^{Tan} | Water (pH:7.0) |
| 6 | TiNS^{PDDA} | Tris hydrochloride buffer (1mM; pH:2.3) |
| 7 | TiNS^{Cho} | Water (pH:7.0) |
| 9 | GONS^{Cas} | Tris hydrochloride buffer (1mM; pH:7.7) |

As were the cases with the nanosheets with no coating agent, split peaks were observed, indicating that the nanosheets and water molecules were both magnetically oriented in the magnetic field.

### (9) Orientation property evaluation for glucose

Next, ¹³C-NMR spectroscopy for the glucose labeled with ¹³C was performed by using TiNS or NbNS.

The NMR testing samples were obtained by adding 3 wt% of glucose to the TMA solution (1 mM) of TiNS (1.5 wt%) or to the TBA solution (1 mM) of NbNS (4 wt%). The obtained results were shown in FIGs. 18A to 18C.

FIG. 18A shows the measured result for the ¹³C labeled glucose with no additive nanosheet. FIG. 18B shows the measured result with the addition of TiNS. FIG. 18C shows the measured result with the addition of NbNS. It was found from the coupling shift of ¹³C that the peaks were shifted for the cases when TiNS or NbNS is added as compared to the case of no nanosheet addition, which shows that the β glucose molecules were oriented.

### (10) Orientation property evaluation for protein

TiNS^{Cas} or NbNS^{Cas} was used to perform NMR spectroscopy for the β1 domain of protein G labeled with ¹⁵N (¹⁵N-GB1). ¹⁵N-GB1 (4.0 mg/mL) was added to the Tris-hydrochloride buffer solution (10 mM; pH: 6.8) (D₂O=10%) of TiNS^{Cas}(2.5 wt%) or NbNS^{Cas}(4.1 wt%) to obtain NMR testing samples. The measurement for TiNS^{Cas} was performed at various measuring temperatures ranging from 5 to 80 °C. The test for NbNS^{Cas} was performed at 35 °C.

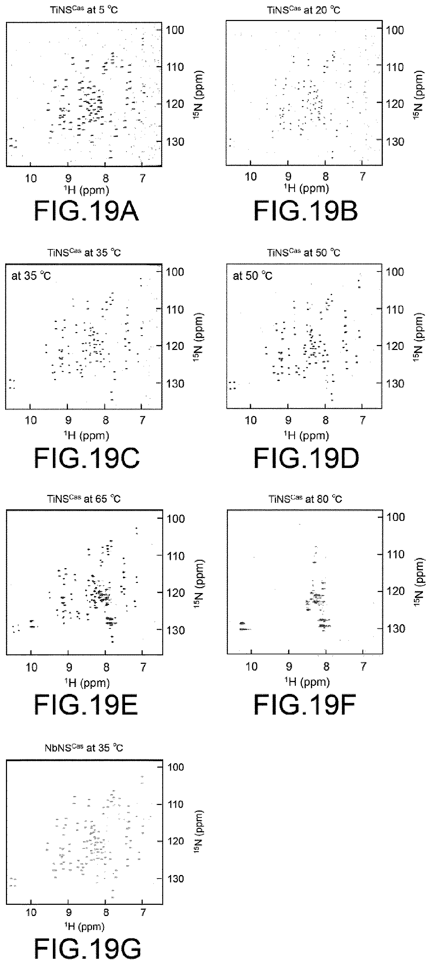

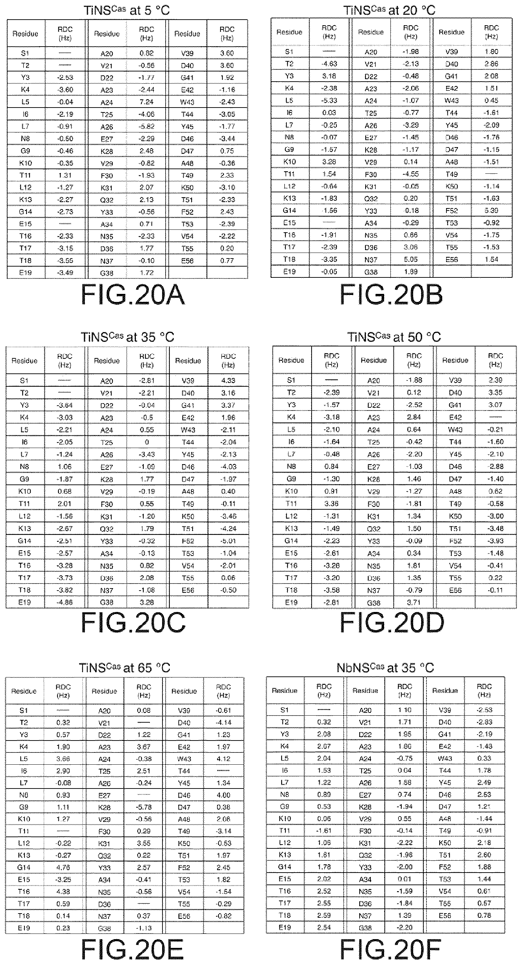

FIGs. 19A to 19G show IPAP-HSQC spectra. FIGs. 20A to 20F show lists of Residual Dipolar Coupling (RDC) calculated from the IPAP-HSQC spectra of ¹H-¹⁵N couplings that originate from amino acid backbones. It was found that both IPAP-HSQC spectra and RDC were observed in the presence of nanosheets.

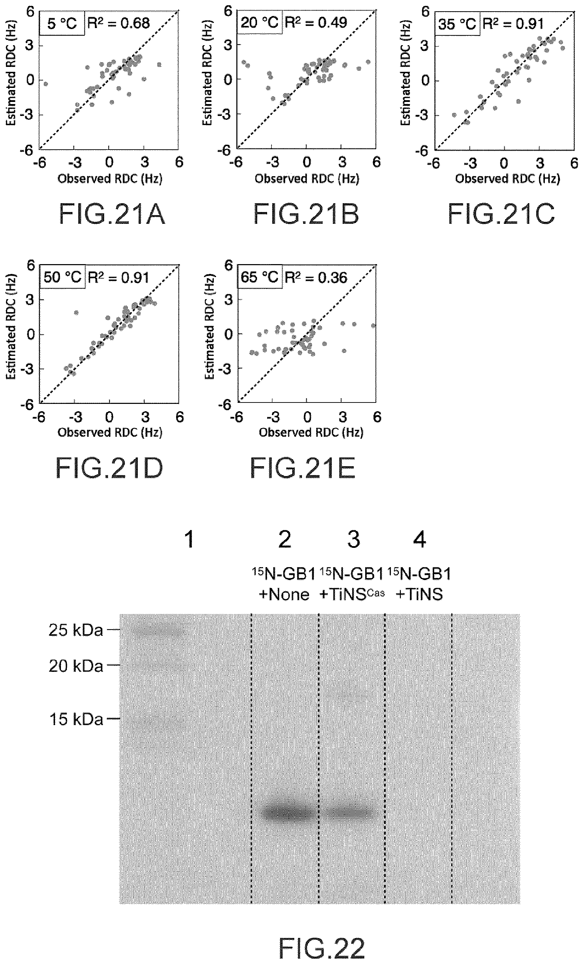

FIGs. 21A to 21E show graphs illustrating correlations between the measured RDC data for TiNS^{Cas} and the corresponding RDC data estimated from the reported structures for various measurement temperatures (from 5 to 65 °C).

The graphs indicated a high correlation for the reported GB1 (Protein Data Bank Japan (PDBj): 2PLP) at both 35 °C and 50 °C while the graphs showed a low correlation at 5, 20 and 65 °C. It was thus found that structural change in GB1 has occurred.

It was hence revealed that the nanosheet according to the present invention functions as a protein orientation agent for NMR spectroscopy in a temperature range wider than those of the prior orientation agents.

Next, TiNS^{Cas} (2.5 wt%) and ¹⁵N-GB1(4 mg/mL) were mixed in Tris-hydrochloride buffer solution (10 mM; pH: 6.8) for two hours before being centrifuged (15,000rpm) to obtain a supernatant solution.

In a similar way, TiNS (1.5 wt%) and ¹⁵N-GB1(4 mg/mL) were mixed in Tris-hydrochloride buffer solution (10 mM; pH: 6.8) for two hours before being centrifuged to obtain another supernatant solution.

The respective supernatant solutions underwent SDS-Poly-Acrylamide Gel Electrophoresis (SDS-PAGE). FIG. 22 shows the obtained result of SDS-PAGE. The 1^{st} lane indicates the protein markers, 2^{nd} lane indicates ¹⁵N-GB1, 3^{rd} lane indicates TiNS^{Cas} supernatant solution and 4^{th} lane indicates TiNS supernatant solution.

A band originating from ¹⁵N-GB1 was detected in the TiNS^{Cas} supernatant solution. It was thus confirmed that ¹⁵N-GB1 is collectable from the supernatant solution.

It was found that the nanosheet coated with the coating agent of the present invention allows one, by a simple centrifugation process, to collect target proteins for NMR spectroscopy that used to be uncollectable by the prior orientation agents, and that the nanosheets itself are reusable.

## Claims

1. An orientation agent for NMR spectroscopy comprising:
a nanosheet; and
a compound having a molecular weight of 1,500 or more and containing 35 or more functional groups per molecule, said functional groups being composed of at least one selected from a hydroxy group, an amino group, an amide group, a carbonyl group, a carboxyl group, a sulfo group, a phosphate group, an imidazole group and a guanidine group,
wherein the nanosheet is coated with the compound.

2. The orientation agent for NMR spectroscopy according to claim 1, wherein the nanosheet has a thickness of 0.5 to 3 nm and a size of 100 nm to 100 µm.

3. The orientation agent for NMR spectroscopy according to claim 1 or 2, wherein the nanosheet is a nanosheet comprising at least one selected from titanium oxide, niobium oxide and graphene oxide.

4. The orientation agent for NMR spectroscopy according to any one of the preceding claims, wherein the compound is at least one selected from proteins, tannic acid, poly(diallyldimethylamine chloride) and chondroitin sulfate.

5. The orientation agent for NMR spectroscopy according to claim 4, wherein the proteins include at least one selected from casein, lysozyme and albumin.

6. A titanium oxide nanosheet coated with at least one selected from proteins, tannic acid, poly(diallyldimethylamine chloride) and chondroitin sulfate.

7. A niobium oxide nanosheet coated with casein.

8. A graphene oxide nanosheet coated with casein.
